(19) **Europäisches Patentamt / European Patent Office / Office européen des brevets**

(11) **EP 4 568 423 A1**

(12) **EUROPEAN PATENT APPLICATION**
published in accordance with Art. 153(4) EPC

(43) Date of publication:
**11.06.2025 Bulletin 2025/24**

(21) Application number: **23859942.7**

(22) Date of filing: **01.08.2023**

(51) International Patent Classification (IPC):
$H05B\ 47/105^{(2020.01)}$  $H05B\ 47/175^{(2020.01)}$
$H05B\ 45/18^{(2020.01)}$

(52) Cooperative Patent Classification (CPC):
**H05B 45/18; H05B 47/105; H05B 47/175**

(86) International application number:
**PCT/JP2023/028092**

(87) International publication number:
**WO 2024/048173 (07.03.2024 Gazette 2024/10)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **01.09.2022 JP 2022139227**

(71) Applicant: **Ushio Denki Kabushiki Kaisha Tokyo 100-8150 (JP)**

(72) Inventor: **MATSUSHIMA Takeo Tokyo 100-8150 (JP)**

(74) Representative: **Maiwald GmbH
Engineering
Elisenhof
Elisenstrasse 3
80335 München (DE)**

(54) **OPTICAL OUTPUT CONTROL SYSTEM**

(57) Provided is an optical output control system that takes into consideration individual differences among light source devices even with a smaller amount of data than a conventional control method using a feedforward method. The optical output control system includes: a light source unit including a light-emitting element; a current supply unit that supplies current to the light source unit; a temperature detecting unit that detects an environmental temperature of the light source unit; and a control unit that controls a current amount supplied from the current supply unit to the light source unit on the basis of an execution control function in which a relationship among a first variable corresponding to a target value related to optical output of the light source unit, a second variable corresponding to the environmental temperature detected by the temperature detecting unit, and a third variable corresponding to the current amount supplied to the light source unit is defined by using one or a plurality of coefficients. The control unit is configured to be able to update at least one of the coefficients constituting the execution control function on the basis of coefficient update information that is input.

Fig. 1

**Description**

TECHNICAL FIELD

The present invention relates to an optical output control system.

BACKGROUND ART

It is known that a light-emitting element such as a light-emitting diode (LED) varies in an amount of light emission depending on the temperature even when the same amount of electric current is applied. Under such a background, as a technique for stabilizing optical output of the LED, there is conventional feedback control in which a part of emitted light from the LED is received by a photosensor, and the amount of current supplied from a power supply circuit to the LED is adjusted on the basis of the amount of received light.

However, in the case of the feedback control using a photosensor, the photosensor itself is affected by temperature, resulting in that the optical output is difficult to be controlled with high accuracy. In addition, in the feedback control, the first time of lighting generates optical output without any compensation.

As a countermeasure to such a problem, feedforward control has been proposed in which the temperature of an LED is measured and a value of current supplied to the LED is controlled according to a value of the measured temperature (see, for example, Patent Document 1 below).

PRIOR ART DOCUMENT

PATENT DOCUMENT

Patent Document 1: JP-A-3-36777

SUMMARY OF THE INVENTION

PROBLEMS TO BE SOLVED BY THE INVENTION

According to the method described in Patent Document 1, a data table in which a relationship among the optical output, the temperature, and the current is recorded in advance is prepared, and in order to obtain a desired optical output, control is performed to supply the current corresponding to a current value read from the data table to the LED. However, in order to accurately control the optical output by this method, a huge amount of data needs to be recorded in the data table.

In addition, it is necessary to perform processing of reading data close to the desired optical output and the measured temperature from the data table and complement processing in order to determine a necessary current amount, and therefore, there is a limit to achieving quick responsiveness. In particular, for a light source used in an application, such as an endoscope, in which the optical output is expected to be finely adjusted during illumination, quick responsiveness to the adjustment of the optical output is required, and thus, the above-described control method is difficult to be adopted.

Furthermore, even in the light source devices of the same type, individual differences occur in some cases in the characteristics of the amount of light emission according to the temperature and the current amount indicated by the light-emitting element included in each light source device. Furthermore, even in the same light source device, the characteristics change in some cases at the initial stage and the end of life. In the technique of Patent Document 1 described above, because such individual differences among light source devices and the change in characteristics over time in the same light source device are not considered, it cannot be said that the optical output can be controlled with sufficiently high accuracy.

In view of the above problems, an object of the present invention is to provide an optical output control system that takes into consideration individual differences among light source devices even with a smaller amount of data than a conventional control method using a feedforward method.

MEANS FOR SOLVING THE PROBLEMS

An optical output control system according to the present invention includes:

a light source unit including a light-emitting element;
a current supply unit that supplies current to the light source unit; and
a temperature detecting unit that detects an environmental temperature of the light source unit; and
a control unit that controls a current amount supplied from the current supply unit to the light source unit on the basis of an execution control function in which a relationship among a first variable corresponding to a target value related to optical output of the light source unit, a second variable corresponding to the environmental temperature detected by the temperature detecting unit, and a third variable corresponding to the current amount supplied to the light source unit is defined by using one or a plurality of coefficients, in which

the control unit is configured to be able to update at least one of the coefficients constituting the execution control function on the basis of coefficient update information that is input.

According to the above configuration, when the information regarding the target value of the optical output is input, the control unit applies the information regarding the target value of the optical output and the information regarding the environmental temperature of the light source unit at the current time to the execution control function and performs the arithmetic operation, thereby determining the current amount necessary for obtaining the optical output corresponding to the target value under the environmental temperature at the current time. The current supply unit supplies the amount of current determined by the control unit to the light source unit. This allows the optical output close to the target value to be obtained.

That is, according to the above configuration, because the necessary current amount is determined only by performing simple arithmetic processing by the arithmetic processing unit in the control unit, the optical output can be controlled with a small number of processes. As a result, high responsiveness is achieved.

Furthermore, according to the above configuration, the coefficient included in the execution control function used by the control unit can be updated on the basis of the coefficient update information. Therefore, the optical output can be controlled with high accuracy in consideration of the individual differences of the light source units.

As an example, by updating the coefficient at the timing when the light source unit mounted on the device is replaced, control of the optical output based on the execution control function can be performed, the execution control function including the coefficient reflecting the characteristics of the new light source unit. As another example, by updating the coefficient according to the elapsed time from the start of use of the light source unit, control of the optical output based on the execution control function can be performed, the execution control function including the coefficient reflecting the temporal change in the light emission characteristic of the light source unit.

The environmental temperature of the light source unit detected by the temperature detecting unit may be the temperature of a region (substrate) where the light-emitting element is mounted, or may be the temperature of the light-emitting element itself. In addition, in a case where the light-emitting element is disposed in a closed space, the environmental temperature may be the temperature of the atmosphere in the closed space.

In the present description, the "execution control function" refers to a function indicating a relationship represented by a plurality of variables and a single or a plurality of specified coefficients, and refers to a function in which a unique solution is determined by determining a value of the variable. That is, the function means a function in which the relationship among the first variable corresponding to the target value related to the optical output of the light source unit, the second variable corresponding to the environmental temperature detected by the temperature detecting unit, and the third variable corresponding to the current amount supplied to the light source unit is uniquely determined. Meanwhile, a "control function" refers to a function indicating a relationship represented by a plurality of variables and a single or a plurality of coefficients, but refers to a function in a state in which the value of the coefficient is not specifically determined. That is, the "control function" is a concept that merely defines a "type" of a function, and is a state in which a relationship between the variables is not uniquely determined until the coefficient is determined. Further, a function in a state in which "a single or a plurality of coefficients" defined under the control function are determined corresponds to the "execution control function". As the control function, any function can be used as long as the relationship among the first variable, the second variable, and the third variable can be expressed with necessary accuracy.

The light source unit may include a first storage unit in which the coefficient update information is recorded, and the control unit may read the coefficient update information recorded in the first storage unit and update the execution control function.

In the above configuration, the timing at which the control unit reads the coefficient update information recorded in the first storage unit mounted on the light source unit is optional. As a typical example, after the light source unit is mounted on the system, the control unit can be configured to read the coefficient update information from the first storage unit at a timing of initial setting performed on the light source unit. The coefficient update information that has been read may be held in the control unit, and thereafter, may be used at the time when the light source unit is driven.

As another example, the control unit may read the coefficient update information recorded in the first storage unit at a timing artificially designated by an operator. The artificial timing referred to herein may be a timing designated by the operator operating a dedicated input interface (such as buttons and touch panels) provided in a housing on which the control unit is mounted, or may be a timing designated remotely by the operator operating an operation terminal communicatively connectable to the control unit.

As still another example, the control unit may periodically read the coefficient update information recorded in the first storage unit at a predetermined time.

The optical output control system may further include a storage medium attaching unit that can be attached with a storage medium in which the coefficient update information is recorded, and

the control unit may read the coefficient update information recorded in the storage medium attached to the storage medium attaching unit and update the execution control function.

According to the above configuration, even in a case where the optical output control system cannot be connected to the electrical communication line such as the Internet, the optical output control system can update the coefficient applied to the execution control function by attaching the storage medium in which the information regarding the coefficient is recorded in the storage medium attaching unit.

The storage medium attaching unit may be provided in the light source unit, or may be provided at a location different from the light source unit in the optical output control system.

The optical output control system may further include an update information transmission device configured to be able to transmit the coefficient update information to the control unit via an electrical communication line.

The update information transmission device may be a stationary computer or a portable terminal device such as a smartphone or a tablet computer. The update information transmission device may be a cloud server. The update information transmission device and the control unit may be connected to each other by wire or wirelessly.

The update information transmission device may include a second storage unit in which the coefficient update information is recorded, and may transmit the coefficient update information recorded in the second storage unit to the control unit.

EFFECT OF THE INVENTION

According to the present invention, the optical output can be controlled with high accuracy even with a smaller amount of data than that of a control method using a conventional feedforward method.

BRIEF DESCRIPTION OF THE DRAWINGS

Fig. 1 is a block diagram schematically illustrating a configuration of a first embodiment of an optical output control system according to the present invention.

Fig. 2 is a graph illustrating an example of a result obtained by measuring an optical output P and a temperature T with a current amount I being varied.

Fig. 3 is a graph visually displaying an execution control function obtained by fitting a control function to a plurality of coordinate groups obtained in Fig. 2.

Fig. 4 is a graph showing a result obtained by comparing a calculated value of a current amount calculated by using the execution control function obtained based on the result in Fig. 3 with an actually measured current amount.

Fig. 5A is a graph showing a result in a case where control is performed by a method (feedback) according to a comparative example, and shows a temporal change in a target value of optical output, an actual measurement value of the actual optical output, and dispersion between the target value and the actual measurement value.

Fig. 5B is a graph showing a result in a case where control is performed by the method (feedback) according to the comparative example, and shows a temporal change in the amount of current supplied to the light-emitting element and a temperature of an installation location of the light-emitting element.

Fig. 6A is a graph showing a result in a case where control is performed by a method (feedforward using the execution control function) according to an example, and shows a temporal change in a target value of optical output, an actual measurement value of the actual optical output, and dispersion between the target value and the actual measurement value.

Fig. 6B is a graph showing a result in a case where control is performed by the method (feedforward using the execution control function) according to the example, and shows a temporal change in the amount of current supplied to the light-emitting element and a temperature of an installation location of the light-emitting element.

Fig. 6C is an enlarged graph of a partial region in Fig. 6B.

Fig. 7 is a block diagram schematically illustrating a configuration of a second embodiment of an optical output control system according to the present invention.

Fig. 8 is a block diagram schematically illustrating a configuration of a third embodiment of an optical output control system according to the present invention.

Fig. 9 is a block diagram schematically illustrating another configuration of the third embodiment of the optical output control system according to the present invention.

Fig. 10A is a graph schematically illustrating an example of a relationship between the current amount I and the optical output P for each temperature T of the light-emitting element.

Fig. 10B is a graph schematically explaining a method of deriving values of a differential quantum efficiency $\eta_T$ and a threshold current $I_{thT}$ under an optional temperature T.

MODE FOR CARRYING OUT THE INVENTION

[First embodiment]

A first embodiment of an optical output control system according to the present invention will be described with reference to the drawings as appropriate.

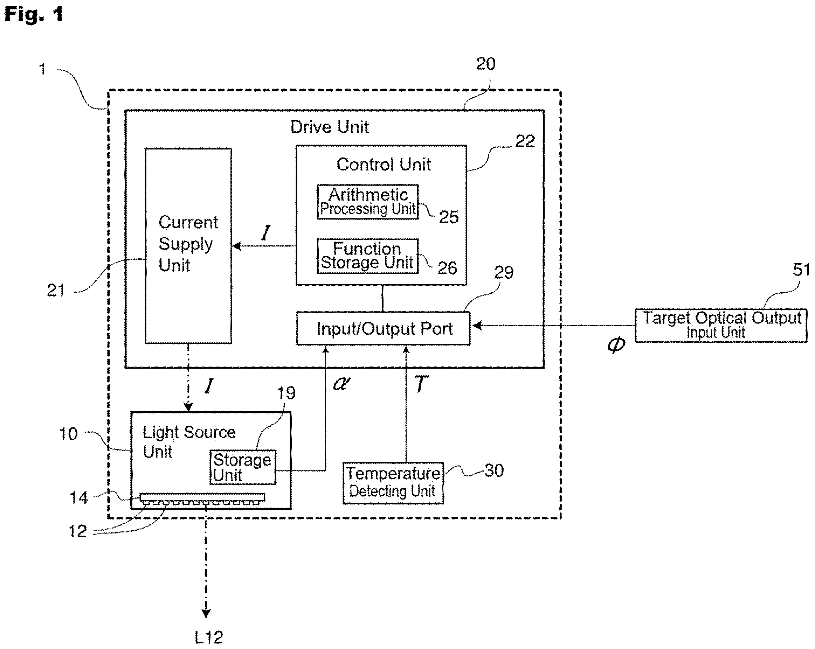

Fig. 1 is a block diagram schematically illustrating an example of a configuration of the optical output control system according to the present invention. An optical output control system 1 includes a light source unit 10, a drive unit 20 that supplies power to the light source unit 10, and a temperature detecting unit 30 that detects an environmental temperature of the light source unit 10. Note that a target optical output input unit 51 illustrated in Fig. 1 will be described later.

In Fig. 1, a solid arrow indicates a flow of information, a one-dot chain line arrow indicates a flow of light, and a two-dot chain line arrow indicates a flow of current supplied to the light source unit 10. The same applies to the drawings referred to hereinafter.

The light source unit 10 includes a substrate 14 on which one or a plurality of light-emitting elements 12 are mounted and a not-illustrated cooling mechanism. Examples of the cooling mechanism include a heat sink, a fan, a water-cooled plate, and a heat pipe. The light-emitting element 12 emits light L12 when supplied with current. The light-emitting element 12 is typically an LED, but may be another solid-state light source element such as a laser diode element.

In the optical output control system 1 according to the present embodiment, the light source unit 10 includes a storage unit 19. The storage unit 19 includes a storage medium such as a hard disk or a flash memory. The storage unit 19 corresponds to a "first storage unit". Information recorded in the storage unit 19 will be described later.

The drive unit 20 includes a current supply unit 21, a control unit 22, and an input/output port 29. The current supply unit 21 is connected to a not-illustrated power supply, and supplies the current to the light-emitting element 12. The control unit 22 is functional means that controls an amount of current supplied from the current supply unit 21 to the light-emitting element 12. The input/output port 29 is an interface that receives input of information from the outside of the drive unit 20 and outputs information to the outside of the drive unit 20. Note that, in the present embodiment, an input port having no output function may be used instead of the input/output port 29.

The temperature detecting unit 30 outputs information regarding a temperature T of in the vicinity of the installation location of the light-emitting element 12 to the input/output port 29 at intervals of, for example, several milliseconds to several ten seconds. As the temperature detecting unit 30, known temperature measuring means such as a radiation thermometer or a thermistor can be used as long as the temperature detecting unit can detect the temperature and output the detected information. The installation location of the temperature detecting unit 30 is not limited as long as the environmental temperature of the light source unit 10, more specifically, the environmental temperature of the light-emitting element 12 can be detected. For example, the temperature detecting unit 30 may be built in the light source unit 10 or may be installed in the vicinity of the outside of the light source unit 10.

The target optical output input unit 51 is means configured to receive input of an instruction signal for adjusting the optical output of the light source unit 10, and is typically operated by a user. As an example, the target optical output input unit 51 includes, for example, an operation button, a knob, a dial, a scroll bar on a touch panel, an input form, and the like. The target optical output input unit 51 may be attached to a housing on which the drive unit 20 is mounted, or may be constituted of an operation terminal, a smartphone, or the like provided at a position away from the drive unit 20. In addition, the target optical output input unit 51 may input a target value by a program or a sequence. As an example, an operation in which the irradiation time, the light intensity, the lighting interval, and the like are programmed is executed. Furthermore, the target value may be input by separate detection means. As an example, in order to make the illuminance of an irradiation surface constant, distance information can be measured, and an optical output value corresponding to the distance can be input as the target value.

In the case where the user desires to increase or decrease the optical output of the light L12 at the present time point, the user operates the target optical output input unit 51 to instruct a desired optical output. Information regarding the desired optical output (information corresponding to a target value Φ) input through the target optical output input unit 51 is input to the control unit 22 via the input/output port 29.

The control unit 22 includes an arithmetic processing unit 25 and a function storage unit 26. In the function storage unit 26, information regarding a control function and an execution control function to be described later is recorded. The information regarding the control function is, for example, function information such as a quadratic function, a trigonometric function, and a two-dimensional multi-linear combination function determined by optional variables and coefficients. In addition, the information regarding the execution control function is information including specific numerical information of the coefficient in addition to the information regarding the control function described above. The function storage unit 26 includes a storage medium such as a hard disk or a flash memory. The arithmetic processing unit 25 applies the information of the environmental temperature T of the light source unit 10 input from the temperature detecting unit 30 and the information of the target value Φ of the optical output input from the target optical output input unit 51 to the execution control function recorded in the function storage unit 26, thereby calculating a supply current amount I (hereinafter, abbreviated as "current amount I") necessary for obtaining the optical output of the target value Φ under the temperature T by arithmetic processing. The arithmetic processing unit 25 includes software or dedicated hardware that can execute such arithmetic processing.

Information regarding the current amount I determined by the arithmetic processing unit 25 is output from the control unit 22 to the current supply unit 21. The current supply unit 21 supplies an amount of current corresponding to the current amount I to the light-emitting element 12. The arithmetic processing unit 25 calculates the supply current amount I by performing the arithmetic processing every time the information regarding the temperature T is input from the temperature detecting unit 30. The current supply unit 21 adjusts the amount of current supplied to the light-emitting element 12 every time the information regarding the supply current amount I is updated from the control unit 22.

In the present embodiment, the light source unit 10 includes the storage unit 19. In this storage unit 19, information (hereinafter, referred to as "coefficient update information") used to update the coefficient applied to the control function is recorded. The control unit 22 reads the coefficient update information from the storage unit 19 via the input/output port 29 at an optional timing, and updates the coefficients constituting the execution control function. The updated execution control function is recorded in the function storage unit 26.

Next, the control function recorded in the function storage unit 26 will be described. As the control function, any function can be used as long as a relationship among a variable (first variable) corresponding to the target value φ related to the optical output of the light source unit 10, a variable (second variable) corresponding to the environmental temperature of the light source unit 10 detected by the temperature detecting unit 30, and a variable (third variable) corresponding to the current amount I supplied to the light source unit 10 can be expressed with necessary accuracy. Hereinafter, a description will be made with reference to an example of the control function.

In the optical output control system 1, an optional control function including the first variable, the second variable, and the third variable is set in the function recording unit 26, and for example, at a time point before shipment, processing of deriving coefficient data constituting the execution control function more suitable for a relationship of each variable of the actual light source unit 10 is performed. Information regarding the execution control function determined by this processing (information regarding the control function and coefficient information) is shipped in a state of being recorded in the function storage unit 26.

An example of derivation of a coefficient of the control function recorded in the function storage unit 26 will be described. After the amount of current supplied from the current supply unit 21 to the light-emitting element 12 is intentionally changed, an optical output P of the light L12 obtained at this time and the temperature T detected by the temperature detecting unit 30 are associated with the current amount I to acquire a plurality of coordinates (P, T, I). Then, the coefficient of the control function is derived by performing fitting processing on the obtained coordinate group.

The information regarding the optical output P can be detected on the basis of, for example, an amount of light received by a light receiving sensor installed outside light source unit 10. In addition, the information regarding the current amount I may be acquired on the basis of information output from the control unit 22 to the current supply unit 21, or may be acquired on the basis of information obtained by actually measuring the amount of current supplied from the current supply unit 21 to the light-emitting element 12 by using a current sensor or the like.

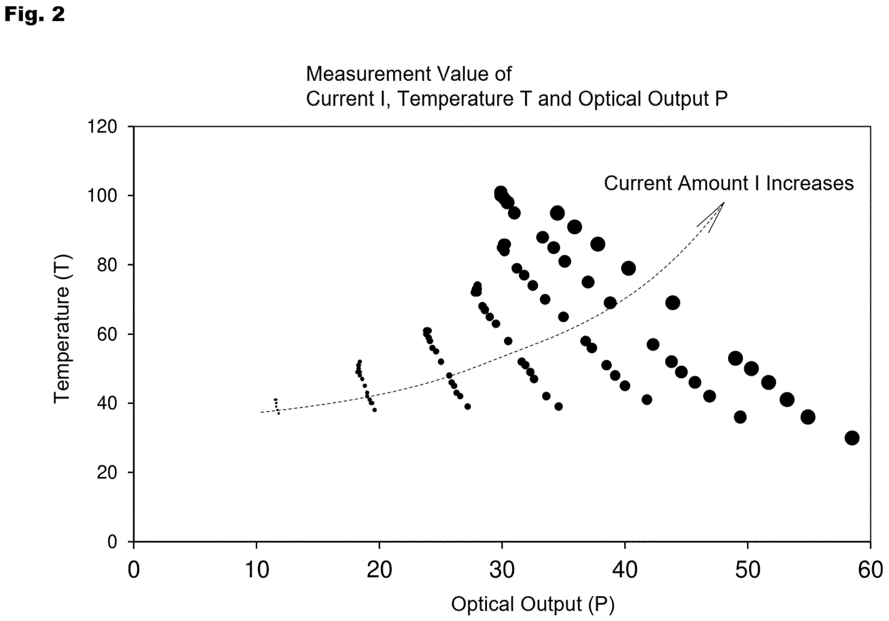

Fig. 2 is a graph illustrating an example of a result obtained by measuring the optical output P of the light L12 and the temperature T detected by the temperature detecting unit 30 with the current amount I being varied. In Fig. 2, the size of a circle corresponds to the magnitude of the current amount I. It is understood that the optical output P varies depending on the temperature T despite the current amount I being the same, and there is regularity in the variation manner. In addition, it is understood that the optical output P varies depending on the current amount I despite the temperature T being constant, and there is regularity in the variation manner.

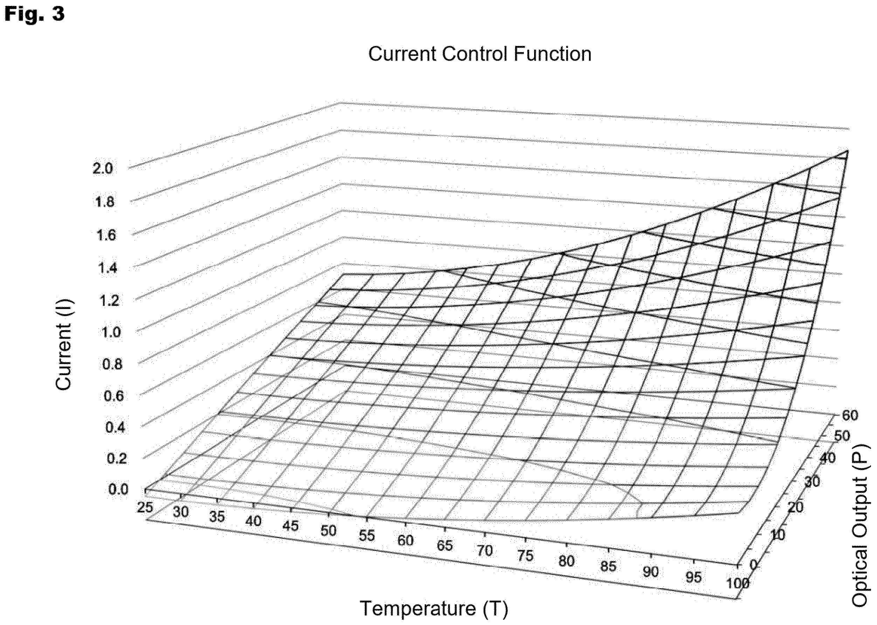

Fig. 3 is a graph visually displaying the execution control function obtained by fitting the control function to the plurality of coordinate groups obtained in Fig. 2. In the example in Fig. 3, the execution control function is expressed as a downwardly convex curved surface shape.

More specifically, the control function defined in the following formula (1) is fitted by using, for example, the least-square method, to a measurement result $(x_i, y_i, z_i)$ (where i = 0, 1, ..., n) obtained by assigning the optical output P to a variable x, the temperature T to a variable y, and the current amount I to a variable z. However, in the formula (1), k and j are integers of 1 or more.

[Math 1]

$$z = \sum_{t=0}^{k} \left( \sum_{s=0}^{j} \alpha_{ts} \cdot y^s \right) \cdot x^t \tag{1}$$

Here, a case where k = 2 and j = 2 will be described in detail as a specific example. In this case, the above formula (1) is specifically defined by the following formula (2).
[Math 2]

$$z = \alpha_{00} + \alpha_{01} \cdot y + \alpha_{02} \cdot y^2$$
$$+ \alpha_{10} \cdot x + \alpha_{11} \cdot x \cdot y + \alpha_{12} \cdot x \cdot y^2 \tag{2}$$
$$+ \alpha_{20} \cdot x^2 + \alpha_{21} \cdot x^2 \cdot y + \alpha_{22} \cdot x^2 \cdot y^2$$

When a coefficient $\alpha_{ts}$ to be obtained is expressed as a column vector C, the coefficient can be defined by the following formula (3).
[Math 3]

$$C = \begin{pmatrix} \alpha_{00} \\ \vdots \\ \alpha_{22} \end{pmatrix} \tag{3}$$

When a measurement result $z_i$ (where i = 0, 1, ..., n) regarding the current amount I is expressed as a column vector B, the measurement result can be defined by the following formula (4).
[Math 4]

$$B = \begin{pmatrix} z_0 \\ \vdots \\ z_n \end{pmatrix} \tag{4}$$

By using the measurement result $x_i$ regarding the optical output P and the measurement result $y_i$ (where i = 0, 1, ..., n) regarding the temperature T, a matrix A expressed by the following formula (5) is defined.
[Math 5]

$$A = \begin{pmatrix} 1 & y_0 & y_0^2 & x_0 & x_0 \cdot y_0 & x_0 \cdot y_0^2 & x_0^2 & x_0^2 \cdot y_0 & x_0^2 \cdot y_0^2 \\ \vdots & \vdots & \vdots & \vdots & \vdots & \vdots & \vdots & \vdots & \vdots \\ 1 & y_n & y_n^2 & x_n & x_n \cdot y_n & x_n \cdot y_n^2 & x_n^2 & x_n^2 \cdot y_n & x_n^2 \cdot y_n^2 \end{pmatrix} \tag{5}$$

At this time, the coefficient $\alpha_{ts}$ defined by the column vector C in the formula (3) is calculated by an arithmetic operation based on the following formula (6). However, $A^T$ is a transposed matrix of the matrix (column vector) A, and $(A^T \cdot A)^{-1}$ is an inverse matrix of a matrix $(A^T \cdot A)$.
[Math 6]

$$C = (A^T \cdot A)^{-1} \cdot A^T \cdot B \tag{6}$$

EP 4 568 423 A1

Each element of the matrix C obtained by the above formula (6) corresponds to the coefficient $\alpha_{ts}$ (t = 0, 1, 2; s = 0, 1, 2). That is, a formula obtained by applying each coefficient $\alpha_{ts}$ to the formula (2) corresponds to the execution control function. This execution control function is a function obtained by fitting the measurement result $(x_i, y_i, z_i)$ (where i = 0, 1, ..., n) by using the least-square method, and corresponds to a curved surface function in the present embodiment. That is, each coefficient $\alpha_{ts}$ is a factor for determining the shape of the above control function.

Then, information regarding the control function calculated in advance by using such a method is recorded in the function storage unit 26 and acts as the execution control function. Taking the control function defined by the above formula (2) as an example, the information regarding the control function is recorded in the function storage unit 26 with the values of the coefficients $\alpha_{ts}$ (t = 0, 1, 2; s = 0, 1, 2) being already recorded. The arithmetic processing unit 25 of the control unit 22 performs arithmetic operations by applying the information regarding the target value $\Phi$ of the optical output input from the target optical output input unit 51 to the variable x of the control function defined by the formula (2), and applying the environmental temperature T of the light source unit 10 input from the temperature detecting unit 30 to the variable y of the same function, and determines the supply current amount I on the basis of the obtained value of z.

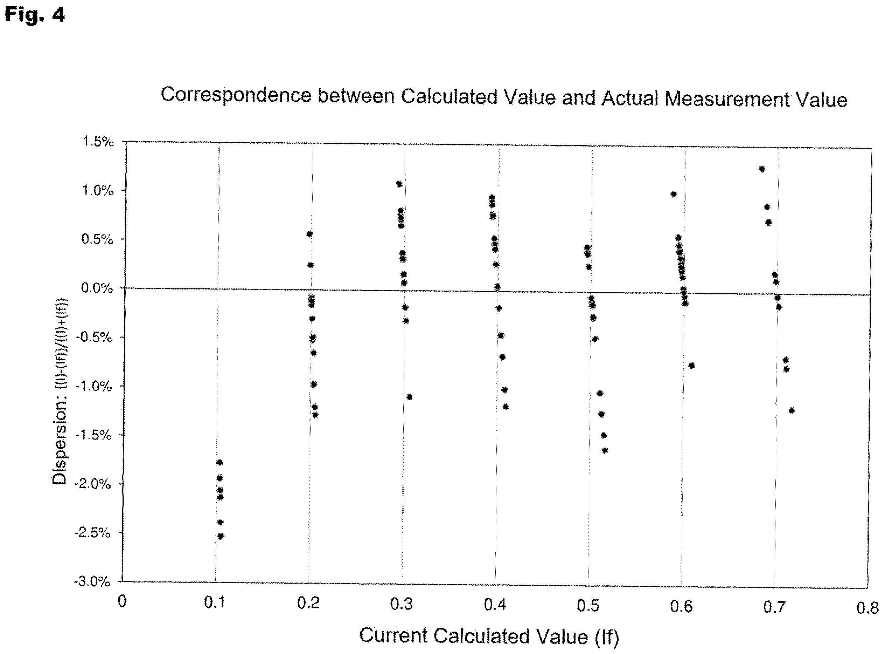

Fig. 4 is a graph showing a result obtained by comparing a calculated value of the current amount calculated by using the execution control function obtained based on the result in Fig. 3 with the actual current amount. The plots on the graph indicate the actual measurement values of the current, and the horizontal axis corresponds to the calculated value of the current calculated on the basis of the values of the optical output P and the temperature T at a location corresponding to the actual measurement. In addition, the vertical axis represents dispersion between the calculated value and the actual measurement value of the current.

According to the result in Fig. 4, it is understood that the actual measurement value and the calculated value substantially correspond to each other, and the value of the dispersion is also extremely small. That is, it can be seen that the characteristics (relationship among the temperature, the current, and the optical output) of the light-emitting element 12 can be expressed by the control function derived on the basis of the actual measurement value.

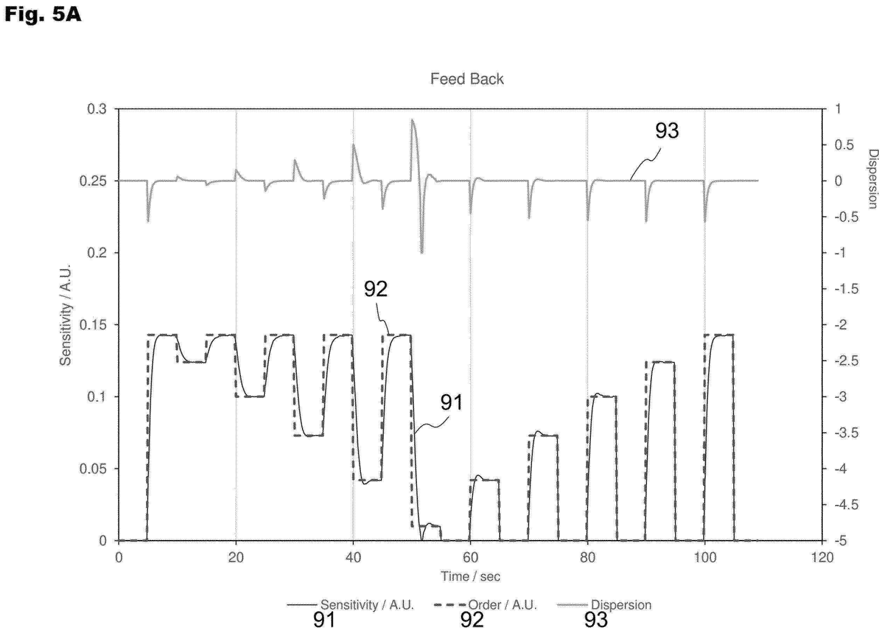

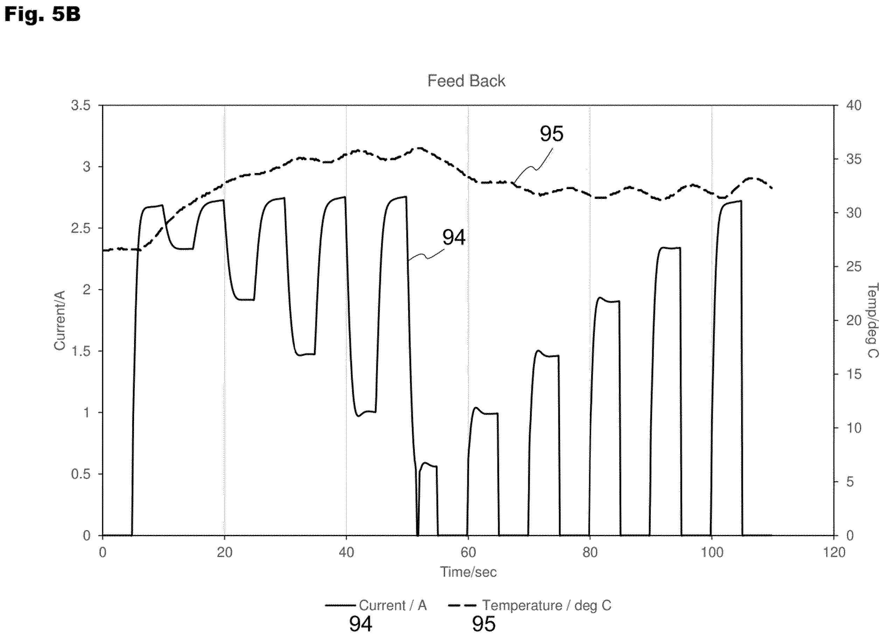

As a comparative example, Figs. 5A and 5B illustrate control results in a case where the light-receiving sensor receives the light L12 emitted from the light-emitting element 12 and feedback control is performed on the basis of the amount of received light. Fig. 5A is a graph illustrating, in a case where the target value of the optical output is changed moment to moment (corresponding to a reference sign 92 in Fig. 5A), a temporal change in the output of the actually received light L12 (corresponding to a reference sign 91 in Fig. 5A) and the dispersion (corresponding to a reference sign 93 in Fig. 5A) between the above two values. In addition, Fig. 5B is a graph illustrating a temporal change in the current flowing through the light-emitting element 12 (corresponding to a reference sign 94 in Fig. 5B) and the temperature detected by the temperature detecting unit 30 (corresponding to a reference sign 95 in Fig. 5B).

On the other hand, a case where the current control is performed on the light-emitting element 12 by the control unit 22 by using the above-described method is set as an example. That is, in the example, in a state where the execution control function is recorded in the function storage unit 26, the arithmetic processing unit 25 of the control unit 22 calculates each of the target value $\Phi$ of the optical output and the environmental temperature T of the light source unit 10 input from the temperature detecting unit 30 by applying each of the target value $\Phi$ of the optical output and the environmental temperature T to the execution control function, and the current corresponding to the current amount I determined with the obtained value z is supplied from the current supply unit 21 to the light-emitting element 12.

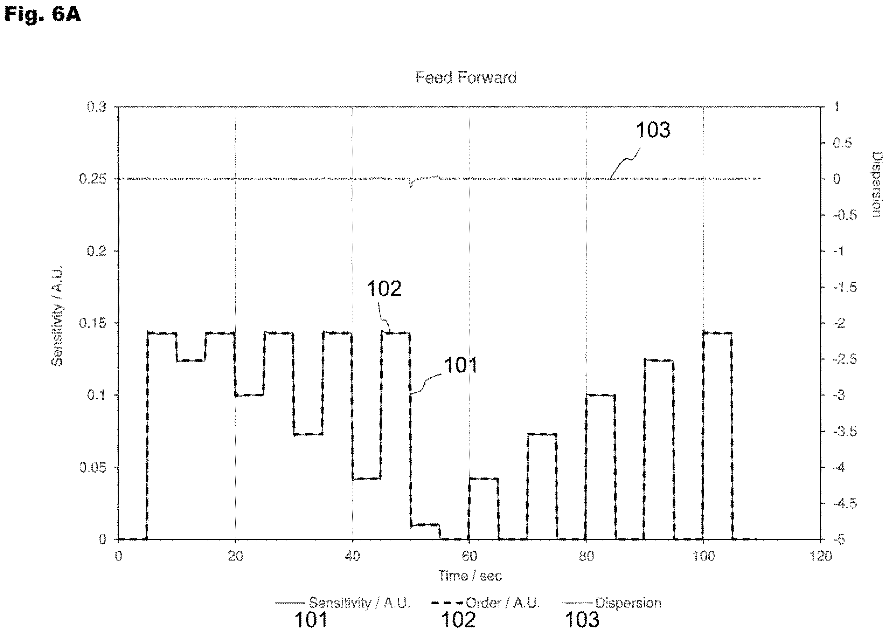

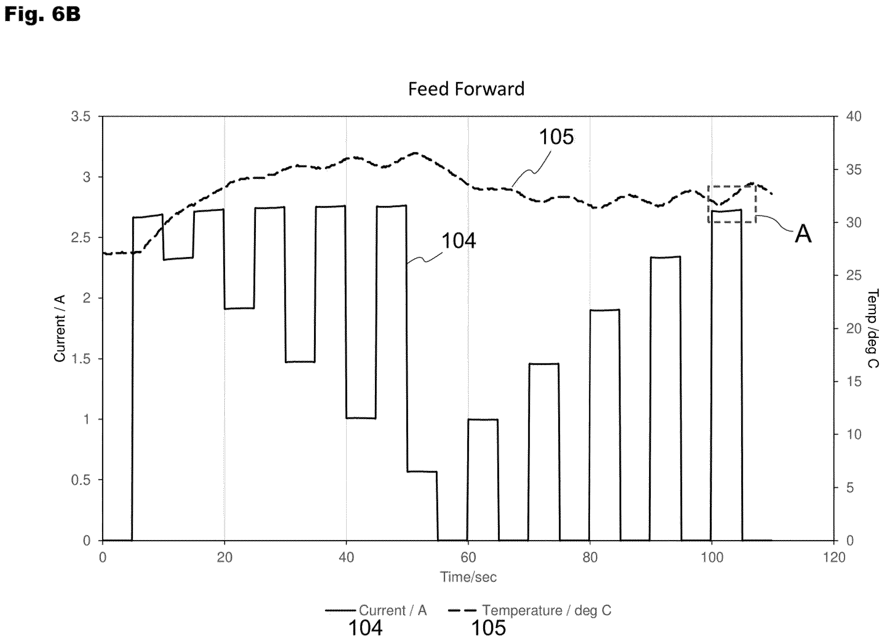

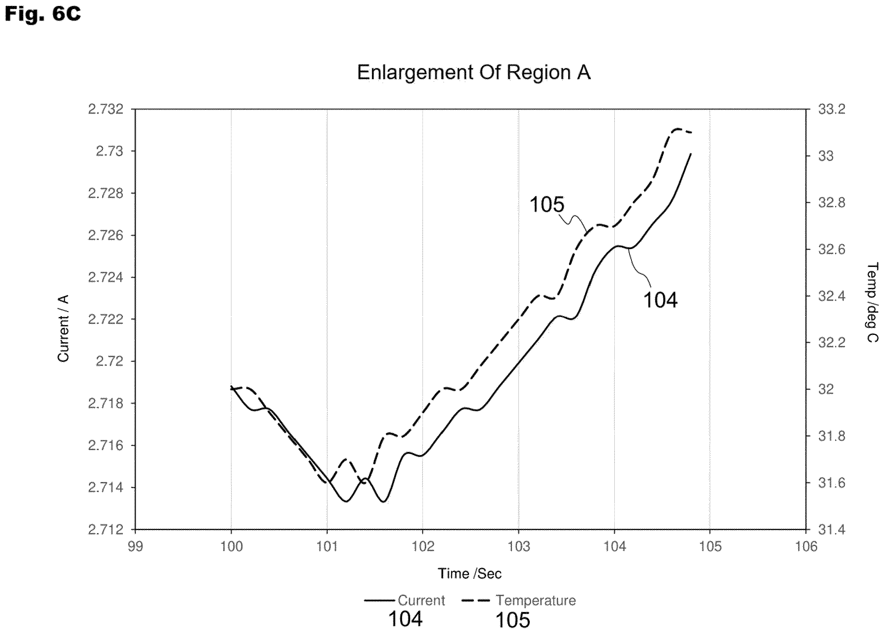

Figs. 6A to 6C show the control result of the example. Fig. 6A is a graph illustrating, in a case where the target value of the optical output is changed moment to moment (corresponding to a reference sign 102 in Fig. 6A), a temporal change in the output of the actually received light L12 (corresponding to a reference sign 101 in Fig. 6A) and the dispersion (corresponding to a reference sign 103 in Fig. 6A) between the above two values. In addition, Fig. 6B is a graph illustrating a temporal change in the current flowing through the light-emitting element 12 (corresponding to a reference sign 104 in Fig. 6B) and the temperature detected by the temperature detecting unit 30 (corresponding to a reference sign 105 in Fig. 6B). Fig. 6C is an enlarged graph of a region A in Fig. 6B.

Fig. 5A is compared with Fig. 6A. In the case of Fig. 5A corresponding to the comparative example, it can be seen that a time of about 3 seconds to 7 seconds is consumed until the actual optical output reaches the target value after the instruction regarding the target value of the optical output is given. Therefore, regarding the optical output, a certain degree of dispersion occurs between the target value and the actual measurement value. On the other hand, in the case of Fig. 6A corresponding to the example, the time taken until the actual optical output reaches the target value after the instruction regarding the target value of the optical output is given is extremely short. This is indicated in Fig. 6A in which a curve 101 and a curve 102 substantially overlap each other and the value of the dispersion is nearly zero at all times.

This can also be understood by comparing Fig. 5B with Fig. 6B. It is understood that the current flowing through the light-emitting element 12 in Fig. 5B corresponding to the comparative example has a larger amount of variation during control than the current flowing through the light-emitting element 12 in Fig. 6B corresponding to the example. This indicates that, in the control method used in the comparative example, because the optical output is deviated from the target value, the control for constantly changing the current amount is performed. However, in the example, the current amount also varies a little according to the temperature change, and this is indicated in Fig. 6C which is an enlarged graph of a portion of the graph in Fig. 6B.

As described above, according to the optical output control system 1 of the present embodiment, even if the instruction to change the target value Φ of the optical output is given, because the amount of current necessary for realizing the target value Φ is determined by calculation by the control unit 22 and the corresponding amount of current is supplied to the light-emitting element 12, control with high responsiveness can be performed.

Incidentally, it is assumed that an operation of replacing the light source unit 10 is performed due to circumstances such as life degradation and failure associated with the lighting time of the light-emitting element 12. When the light source unit 10 is replaced, the light-emitting element 12 itself mounted on the light source unit 10 is also changed. Regarding the relationship between the supply current amount I and the optical output of the light-emitting element 12 under the environmental temperature T of the light source unit 10, there are individual differences present for every light-emitting element 12. This point does not change even if the light-emitting elements 12 mounted on the light source unit 10 are elements of the same model number. That is, in a case where the optical output is controlled after the replacement of the light source unit 10 on the basis of the execution control function recorded in the function storage unit 26 at a time point before replacement of the light source unit 10, there is a possibility that the optical output cannot be controlled with high accuracy.

From such a viewpoint, for example, by performing a lighting test or the like on the light source unit 10 at the time before shipment, the relationship among the environmental temperature T, the supply current amount I, and the optical output P reflecting the characteristics of the light source unit 10 is derived in advance. Then, information regarding a coefficient used at the time when the relationship is defined in a form conforming to the control function is recorded in the storage unit 19. In a case where the control function is in the mode defined in the above formula (1), information regarding the coefficient $\alpha_{ts}$ corresponding to the light source unit 10 is recorded in the storage unit 19. At this time, the information regarding the coefficient $\alpha_{ts}$ corresponding to the light source unit 10 corresponds to the "coefficient update information".

When the light source unit 10 is replaced, the drive unit 20 reads information regarding the coefficient $\alpha_{ts}$ from the storage unit 19 mounted in the newly attached light source unit 10 via the input/output port 29. Then, the execution control function is updated by applying the newly read coefficient $\alpha_{ts}$ to the control function recorded in the function storage unit 26. The information regarding the updated execution control function is recorded in the function storage unit 26. After updating the execution control function once, the control unit 22 may read the execution control function recorded in the function storage unit 26 and perform the above control.

According to the above configuration, even in a case where the light source unit 10 is replaced, the optical output is controlled by using the control function in consideration of the characteristics of the light-emitting element 12 mounted on the newly replaced light source unit 10.

Note that, in the above embodiment, the description has been given assuming that the coefficient update information is the value itself of the coefficient $\alpha_{ts}$ applicable to the control function, but the description mode is not limited as long as the coefficient update information is information that can specify the coefficient applied to the control function.

[Second embodiment]

A second embodiment of an optical output control system according to the present invention will be described focusing on portions different from those of the first embodiment.

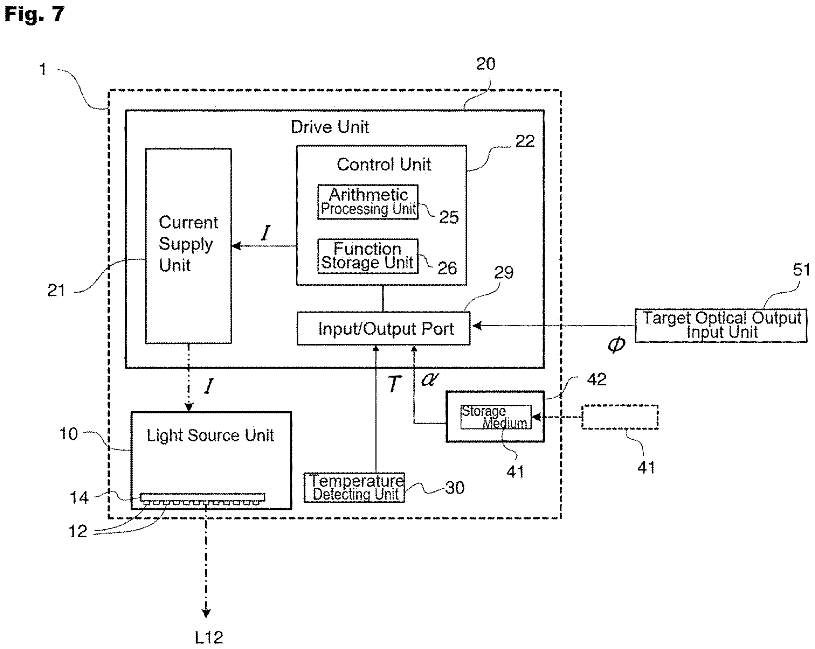

Fig. 7 is a block diagram schematically illustrating an example of a configuration of the optical output control system according to the present invention. An optical output control system 1 of the present embodiment is different from the first embodiment in that a storage medium attaching unit 42 is provided.

The storage medium attaching unit 42 is an interface to which a portable storage medium 41 such as a memory card, a flash memory, or an optical disk can be attached. In the present embodiment, a light source unit 10 does not include a storage unit 19.

In the optical output control system 1 of the present embodiment, a storage medium 41 in which the information regarding the coefficient $\alpha_{ts}$ applicable to the control function is recorded can be attached to the storage medium attaching unit 42. A drive unit 20 reads the information regarding the coefficient $\alpha_{ts}$ from the storage medium 41 attached to the storage medium attaching unit 42 via an input/output port 29. Then, the execution control function is updated by applying the newly read coefficient $\alpha_{ts}$ to the execution control function recorded in a function storage unit 26. The information regarding the updated execution control function is recorded in the function storage unit 26. After updating the execution control function once, the control unit 22 may read the execution control function recorded in the function storage unit 26 and perform the above control.

According to the above configuration, even in a case where the light source unit 10 does not include the storage unit 19 in which the information regarding the coefficient is recorded, the execution control function can be updated by reading the information regarding the coefficient of the control function from the external storage medium 41. Therefore, in addition to the case described above in the portion of the first embodiment where the light source unit 10 is replaced, the execution control function can be updated at an optional timing even during the same light source unit 10 is used.

For example, a company that provides the light source unit 10 performs a lighting test or the like to derive the information regarding the coefficient (coefficient update information), and this information is recorded in the storage medium 41. Then, the storage medium 41 in which the coefficient update information is recorded is provided to a user. The user attaches the storage medium 41 to the storage medium attaching unit 42. With this configuration, the execution control function can be updated.

Note that, in the present embodiment, the light source unit 10 may include the storage unit 19.

[Third embodiment]

A third embodiment of an optical output control system according to the present invention will be described focusing on portions different from those of the first embodiment.

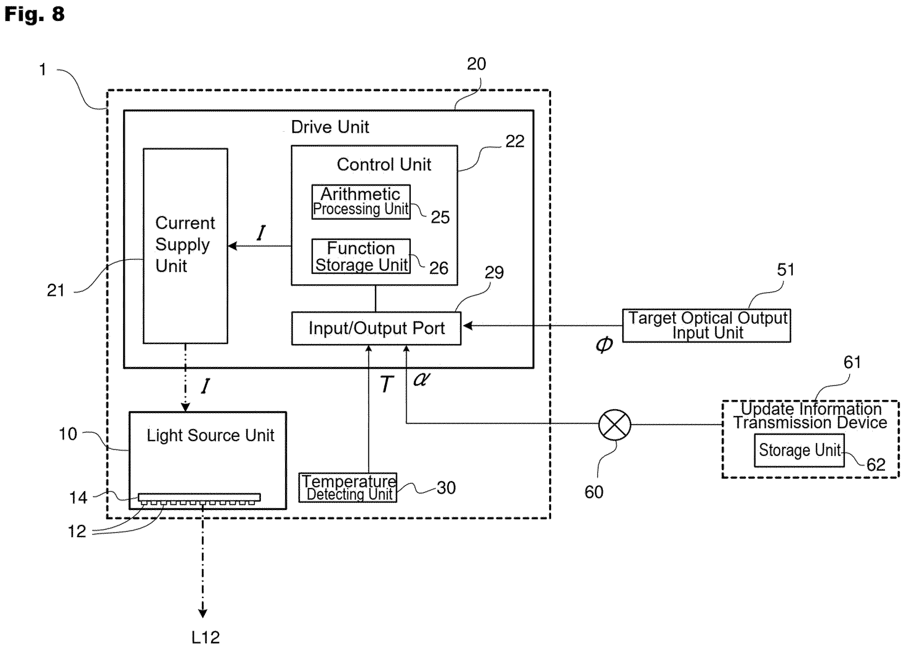

Fig. 8 is a block diagram schematically illustrating an example of a configuration of the optical output control system according to the present invention. The optical output control system 1 of the present embodiment is different from the first embodiment in that an update information transmission device 61 is provided. In addition, in the present embodiment, a light source unit 10 does not include a storage unit 19.

The update information transmission device 61 is a device that can be connected to an input/output port 29 via an electrical communication line 60 such as the Internet, and includes a terminal-type computer or server. The update information transmission device 61 includes a storage unit 62 in which the information regarding the coefficient $\alpha_{ts}$ applicable to the control function is recorded. The storage unit 62 corresponds to a "second storage unit". The update information transmission device 61 transmits the information regarding the coefficient $\alpha_{ts}$ recorded in the storage unit 62 to a drive unit 20 through the electrical communication line 60.

The drive unit 20 receives the information regarding the coefficient $\alpha_{ts}$ transmitted via the input/output port 29, and updates the execution control function by applying the newly read coefficient $\alpha_{ts}$ to the execution control function recorded in a function storage unit 26. The information regarding the updated execution control function is recorded in the function storage unit 26. After updating the execution control function once, the control unit 22 may read the execution control function recorded in the function storage unit 26 and perform the above control.

According to the above configuration, even in a case where the light source unit 10 does not include the storage unit 19 in which the information regarding the coefficient is recorded, the execution control function can be updated by receiving the information regarding the control function transmitted from the update information transmission device 61 on the drive unit 20 side. Therefore, in addition to the case described above in the portion of the first embodiment where the light source unit 10 is replaced, the execution control function can be updated at an optional timing even during the same light source unit 10 is used.

For example, a company that provides the light source unit 10 performs a lighting test or the like to derive the information regarding the coefficient (coefficient update information), and this information is recorded in the storage unit 62. The coefficient update information recorded in this storage unit 62 is transmitted from the update information transmission device 61 to the drive unit 20 via the electrical communication line 60. With this configuration, the execution control function can be updated.

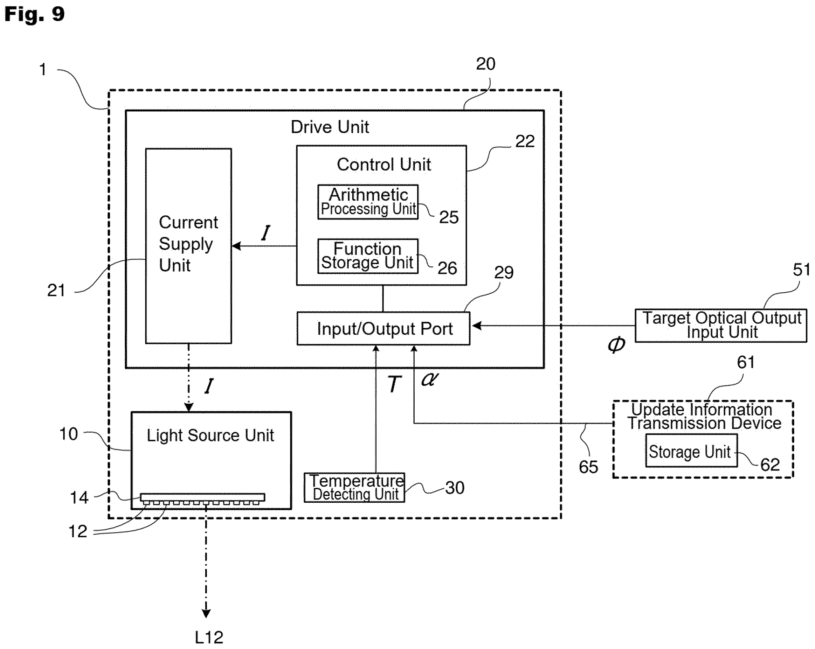

Note that, as illustrated in Fig. 9, the update information transmission device 61 may be connected to the input/output port 29 by a wired signal line 65, and the coefficient update information may be transmitted to the input/output port 29 through this signal line 65.

In the present embodiment, the light source unit 10 may include the storage unit 19.

[Other embodiments]

Hereinbelow, other embodiments will be described.

<1> The control function described above in the first embodiment is merely an example, and the present invention is not limited to the form of the control function described above.

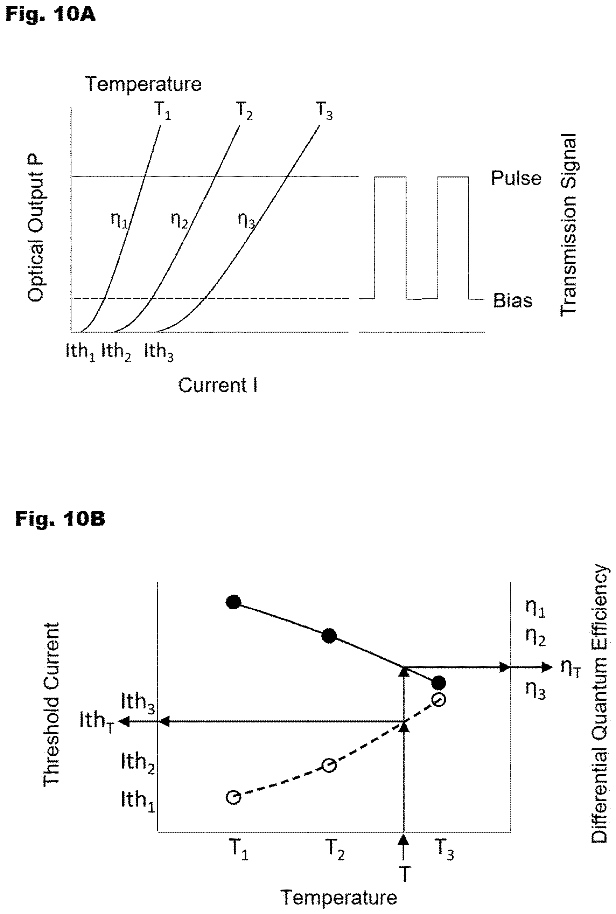

In a case where the light-emitting element 12 is a solid-state light source element such as an LED, it is necessary to supply a current equal to or more than a threshold current $I_{th}$ in order to cause light emission. It is assumed that individual differences occur in the value of the threshold current $I_{th}$ for every light-emitting element 12. In addition, under the same temperature T, the individual differences possibly occur for every light-emitting element 12 in a curve indicating the relationship between the current amount I equal to or more than the threshold current $I_{th}$ and the optical output P (see Fig. 10A).

As illustrated in Fig. 10A, by deriving the curves for every temperature, a differential quantum efficiency $\eta$ corresponding to the slope of the curve is calculated. In this case, the relationship between the supply current amount I and the optical output P at a certain temperature T1 is defined as a function $f_{T1}(I, P)$ having the differential quantum efficiency

$\eta_1$ and the threshold current $I_{th1}$ as coefficients. By measuring the relationship between the current amount I and the optical output P under a plurality of temperatures T such as temperatures T2 and T3 and performing similar calculations, the differential quantum efficiency $\eta_2$ and the threshold current $I_{th2}$, and the differential quantum efficiency $\eta_3$ and the threshold current $I_{th3}$, ... are obtained.

Then, the values of the differential quantum efficiency $\eta_T$ and the threshold current $I_{thT}$ under another temperature T can be calculated by the complement processing (see Fig. 10B).

According to this method, a function f(I, P, T) of the current amount I, the optical output P, and the temperature T, in which the differential quantum efficiency $\eta$ and the threshold current $I_{th}$, are included in the coefficients, is derived as the execution control function. The arithmetic processing unit 25 uses the target value $\Phi$ (corresponding to the optical output P) of the optical output input from the target optical output input unit 51 and the environmental temperature T of the light source unit 10 input from the temperature detecting unit 30 to perform the complement processing under the temperature from the coefficients $\eta_1$, $\eta_2$, $\eta_3$, ... and the coefficients $I_{th1}$, $I_{th2}$, $I_{th3}$, ... to obtain the differential quantum efficiency $\eta_T$ and the threshold current $I_{thT}$, and applies the differential quantum efficiency $\eta_T$ and the threshold current $I_{thT}$ thus obtained to the function f to calculate the obtained supply current amount I. The current supply unit 21 adjusts the amount of current supplied to the light-emitting element 12 every time the information regarding the supply current amount I is updated from the control unit 22.

In the above case, for example, the information regarding the differential quantum efficiency $\eta$ and the threshold current $I_{th}$ can be input to the drive unit 20 via the input/output port 29 as the coefficient update information $\alpha$. Aspects of the input are as described in the above embodiments.

<2> In the configuration of the third embodiment, it is also possible to adopt a configuration in which the coefficient update information $\alpha$ is periodically transmitted from the update information transmission device 61 to the drive unit 20. With such a configuration, it is possible to automatically update the coefficient of the control function in consideration of the temporal change in the characteristics accompanying the use of the light source unit 10. In this case, the information on the lighting time may be transmitted from the light source unit 10 side to the update information transmission device 61, and the update information transmission device 61 may transmit the coefficient update information $\alpha$ to the light source unit 10 side on the basis of the lighting time.

DESCRIPTION OF REFERENCE SIGNS

1 Optical output control system
10 Light source unit
12 Light-emitting element
14 Substrate
19 Storage unit
20 Drive unit
21 Current supply unit
22 Control unit
25 Arithmetic processing unit
26 Function storage unit
29 Input/output port
30 Temperature detecting unit
41 Storage medium
42 Storage medium attaching unit
51 Target optical output input unit
60 Electrical communication line
61 Update information transmission device
62 Storage unit
65 Signal line
$\alpha$ Coefficient update information

**Claims**

1. An optical output control system comprising:

a light source unit including a light-emitting element;
a current supply unit that supplies current to the light source unit; and

a temperature detecting unit that detects an environmental temperature of the light source unit; and
a control unit that controls a current amount supplied from the current supply unit to the light source unit on a basis of an execution control function in which a relationship among a first variable corresponding to a target value related to optical output of the light source unit, a second variable corresponding to the environmental temperature detected by the temperature detecting unit, and a third variable corresponding to the current amount supplied to the light source unit is defined by using one or a plurality of coefficients, wherein
the control unit is configured to be able to update at least one of the coefficients constituting the execution control function on a basis of coefficient update information that is input.

2.  The optical output control system according to claim 1, wherein

the light source unit includes a first storage unit in which the coefficient update information is recorded, and
the control unit reads the coefficient update information recorded in the first storage unit and updates the execution control function.

3.  The optical output control system according to claim 1, further comprising

a storage medium attaching unit that can be attached with a storage medium in which the coefficient update information is recorded, wherein
the control unit reads the coefficient update information recorded in the storage medium attached to the storage medium attaching unit and updates the execution control function.

4.  The optical output control system according to claim 1, further comprising an update information transmission device configured to be able to transmit the coefficient update information to the control unit via an electrical communication line.

5.  The optical output control system according to claim 4, wherein
the update information transmission device includes a second storage unit in which the coefficient update information is recorded, and transmits the coefficient update information recorded in the second storage unit to the control unit.

**Fig. 1**

**Fig. 2**

Measurement Value of
Current I, Temperature T and Optical Output P

Current Amount I Increases

Temperature (T)

Optical Output (P)

**Fig. 3**

Current Control Function

Optical Output (P)

Temperature (T)

Current (I)

Fig. 4

Correspondence between Calculated Value and Actual Measurement Value

EP 4 568 423 A1

EP 4 568 423 A1

**Fig. 5A**

Feed Back

**Fig. 5B**

Feed Back

94

95

EP 4 568 423 A1

Fig. 6A

## Fig. 6B

Feed Forward

Fig. 6C

## Enlargement Of Region A

EP 4 568 423 A1

**Fig. 7**

EP 4 568 423 A1

**Fig. 8**

EP 4 568 423 A1

**Fig. 9**

EP 4 568 423 A1

## Fig. 10A

## Fig. 10B

## INTERNATIONAL SEARCH REPORT

| International application No. |
| --- |
| **PCT/JP2023/028092** |

| A. | CLASSIFICATION OF SUBJECT MATTER |
| --- | --- |

*H05B 47/105*(2020.01)i; *H05B 47/175*(2020.01)i; *H05B 45/18*(2020.01)i
FI:  H05B47/105; H05B47/175; H05B45/18

According to International Patent Classification (IPC) or to both national classification and IPC

| B. | FIELDS SEARCHED |
| --- | --- |

Minimum documentation searched (classification system followed by classification symbols)

H05B47/105; H05B47/175; H05B45/18

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | JP 2015-019097 A (CANON INC.) 29 January 2015 (2015-01-29) paragraphs [0016]-[0061], fig. 1-5 | 1-5 |

☐ Further documents are listed in the continuation of Box C.    ☑ See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **29 August 2023** | **19 September 2023** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

INTERNATIONAL SEARCH REPORT
Information on patent family members

International application No.

**PCT/JP2023/028092**

| Patent document cited in search report | Publication date (day/month/year) | Patent family member(s) | Publication date (day/month/year) |
|---|---|---|---|
| JP 2015-019097 A | 29 January 2015 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 3036777 A